# EUROPÄISCHE PATENTSCHRIFT

(11) **EP 2 038 920 B1**
(45) Veröffentlichungstag und Bekanntmachung des Hinweises auf die Patenterteilung: **04.07.2012**
(21) Anmeldenummer: 07725502.4
(22) Anmeldetag: 24.05.2007
(51) Int. Cl.: H01L 21/56, H01L 21/683, H01L 23/10, H01L 21/50, B81C 1/00

(54) **VERFAHREN ZUR VERPACKUNG VON BAUELEMENTEN**
METHOD FOR PACKAGING COMPONENTS
PROCÉDÉ D'EMBALLAGE DE COMPOSANTS

(30) Priorität: 10.07.2006 DE 102006032047; 10.07.2006 US 819705 P; 14.11.2006 DE 102006053862
(43) Veröffentlichungstag der Anmeldung: 25.03.2009
(73) Patentinhaber: Schott AG, 55122 Mainz (DE)
(72) Erfinder: MUND, Dietrich, 84101 Obersüssbach (DE); SEIDEMANN, Volker, 55268 Nieder-Olm (DE); PAWLOWSKI, Edgar, 55271 Stadecken-Elsheim (DE); BIERTÜMPFEL, Ralf, 55252 Mainz-Kastel (DE); WÖLFING, Bernd, 55124 Mainz (DE); FLEISSNER, Frank, 95455 Bayreuth (DE); AUCHTER-KRUMMEL, Petra, 55578 Vendershein (DE); BRAUNECK, Ulf, 64823 Gross-Umstadt (DE); HAYDEN, Joseph, S., Clarks Summit, PA 18411 (US); FOTHERINGHAM, Ulrich, 65191 Wiesbaden (DE)
(74) Vertreter: Herden, Andreas F.
(86) Internationale Anmeldenummer: PCT/EP2007/004602
(87) Internationale Veröffentlichungsnummer: WO 2008/006418

(56) Entgegenhaltungen:
- WO-A-02/01634
- DE-A- 19 619 921
- JP-A- 9 082 741
- US-A1- 2001 042 902

## Beschreibung

Die Erfindung betrifft allgemein ein Verfahren zur Verpackung oder Verkapselung von Bauteilen, wie insbesondere elektronischen, auch optoelektronischen integrierten Schaltkreisen und/oder mikroelektromechanischen Bauelementen. Insbesondere betrifft das Verfahren die Herstellung von Abdeckungen für Bauteile mit Funktonssubstraten, bei welchen die lateralen Abmessungen größer als die lateralen Abmessungen der Abdeckung sind. Die Erfindung ist besonders zur teilweisen Verpackung von Bauteilen im Waferverbund geeignet. Bei einer Verpackung im Waferverbund werden Teile der Gehäusung der Chips bereits vor deren Abtrennen vom Wafer aufgebracht.

Zum Stand der Technik gehören unter arderem WO 02/01634 A, US 2001/042902 A1 und JP 09 082741 A sowie DE 196 19 921 A1.

Aus dem Stand der Technik sind dabei auch Verfahren bekannt, mit welchen eine vollständige Gehäusung der Chips auf Waferebene gelingt. Auch ist es bekannt, im Waferverbund bereits Lotkugeln auf die gehäusten Chips aufzubringen. Mit einem derartig verarbeiteten Wafer können dann durch Abtrennen direkt Bauelemente erhalten werden, die beispielsweise als SMD-Bausteine verwendet werden.

Um die aktiven Seiten oder Funktionsbereiche der Bauelemente abzudecken, können beispielsweise Abdeckwafer mit dem Funktionswafer, also dem Wafer, auf welchem die Bauelemente definiert sind; verbunden werden. Allerdings werden in einigen Fällen Kavitäten benötigt, die Funktionsbereiche der Bauelemente umgeben. Dabei ist beispielsweise an verkapselte mikroelektromechanische Bauelemente gedacht, bei welchen die mechanischen Elemente eine gewisse Bewegungsfreiheit benötigen. Auch kann eine direkte Verbindung einer Abdeckung mit den Bauelementen an ihren Funktionsbereichen deren elektronische und/oder im Falle von optoelektronischen Bauelementen auch deren optische Funktion beeinträchtigen.

Wird ein Abdeckwafer zur Verkapselung verwendet und dann einzelne Bauteile aus dem Waferverbund mit Funktionswafer und Abdeckwafer durch Sägen abgetrennt, ergibt sich weiterhin, daß auf den vereinzelten Bauteilen die Abdeckungen jeweils im wesentlichen die gleichen Abmessungen aufweisen, wie die aus dem Funktinswafer abgetrennten Substrate. Anders ausgedrückt, wird dabei die Funktionsseite von Chips oder anderen im Waferverbund hergestellten Bauteilen nach dem Abtrennen vollständig durch die Abdeckung bedeckt. Dies kann allerdings unerwünscht sein, wenn die Chips beispielsweise auf ihrer Funktionsseite durch Drahtbonden kontaktiert werden sollen. In diesem Fall wären dann die Anschlußbereiche für die Drähte dann von der Abdeckung bedeckt. Um Chips für das Drahtbonden mit Abdeckungen zu versehen, wurde dazu bisher eine sogennannte "Pick and Place"-Technik angewandt, bei welcher einzelne Gehäuseteile auf den Funktionswafer aufgesetzt und befestigt werden. Diese Technologie ist jedoch selbst mit einer robotergestützten Fertigung sehr zeitaufwendig und treibt damit die Produktionskosten in die Höhe.

Der Erfindung liegt daher die Aufgabe zugrunde, das Aufbringen von Abdeckungen mit lateralen Abmessungen, die kleiner sind, als die lateralen Abmessungen der vom Funktionssubstrat, wie insbesondere von einem Funktionswafer abgetrennten Teile, zu vereinfachen.

Dazu sieht die Erfindung ein Verfahren zur Herstellung verpackter Bauelemente vor, bei welchem ein plattenförmiges Abdecksubstrat auf einem Trägersubstrat befestigt und dann auf der freiliegenden Seite des plattenförmigen Abdecksubstrats Gräben eingefügt werden, welche das plattenförmige Abdecksubstrat durchtrennen, so daß ein Verbundteil mit dem Trägersubstrat und einzelnen durch die Gräben voneinander getrennten, aber über das Trägersubstrat miteinander verbundenen Abdeckteile erhalten wird, und wobei dann die Abdeckteile des Verbundteils mit einem Funktionssubstrat mit einer Vielzahl von Bauelementen verbunden wird, so daß die Gräben entlang von Trennbereichen auf dem Funktionssubstrat zwischen Funktionsbereichen der Bauelemente verlaufen und die Abdeckteile die Funktionsbereiche abdecken, und wobei dann die Verbindung der Abdeckteile mit dem Trägersubstrat gelöst und das Trägersubstrat entfernt und damit ein Verbund mit dem Funktionssubstrat und einer Vielzahl von Abdeckteilen, welche Funktionsbereiche abdecken, erhalten wird. Durch ein geeignetes Einfügen der Gräben können dabei die Abdeckteile so hergestellt werden, daß deren lateralen Abmessungen kleiner als die lateralen Abmessungen der später aus dem Funktionssubstrat zur Herstellung der Bauteile herausgetrennten Teile.

Die Erfindung erlaubt es dabei, alle gewünschten Abdeckteile für ein Funktionssubstrat, wie insbesondere einem Funktionswafer als Verbund gemeinsam aufzubringen und zu befestigen. Das Befestigen ist dabei demgemäß nicht wesentlich zeitaufwendiger, als etwa das Befestigen eines einstückigen Abdeckwafers. Da aber bereits vor dem Heraustrennen der Bauelemente aus dem Funktionswafer die Abdeckteile durch das Einfügen der Gräben herausgearbeitet werden, bestehen hinsichtlich ihrer lateralen Abmessungen im Verhältnis zu denen der vom Funktionssubstrat herausgetrennten Funktionsteile im wesentlichen keine Einschränkungen. Demgemäß können die Abdeckteile durch Einfügen der Gräben so hergestellt werden, daß die Abdeckteile in zumindest einer Richtung entlang der Seite des Funktionssubstrats, auf welche die Abdeckteile aufgebracht werden, jeweils eine kleinere Abmessung als der Bereich zwischen zwei Trennbereichen aufweisen. Bei einem Funktionswafer, wie etwa einem Halbleiterwafer mit elektronischen, optoelektronischen oder mikroelektromechanischen Bauelementen sind dabei die Bereiche zwischen zwei Trennbereichen die HalbleiterSubstrate der durch Abtrennen entlang der Trennbereiche hergestellten einzelnen Chips.

Insbesondere ermöglicht die Erfindung auch, daß beim Aufbringen der Abdeckteile Kavitäten definiert werden, welche die Funkionsbereiche umgeben. Dies kann insbesondere durch ein Verfahren erreicht werden, bei welchem auf dem plattenförmigen Abdecksubstrat eine strukturierte Zwischenschicht aufgebracht wird, welche so strukturiert ist, daß rahmen- oder ringförmige Bereiche des Abdecksubstrats frei bleiben, und wobei dann eine Beschichtung auf der mit der Zwischenschicht versehenen Seite des Abdecksubstrats abgeschieden und die Zwischenschicht danach entfernt wird. Dabei werden die Bereiche der Beschichtung, welche auf der Zwischenschicht abgeschieden sind, zusammen mit der Zwischenschicht entfernt, so daß rahmen- oder ringförmige erhabene Strukturen auf den von der Zwischenschicht freigelassenen rahmenförmigen Bereichen auf dem Abdecksubstrats erhalten werden. Außerdem werden auf der freiliegenden Seite des plattenförmigen Abdecksubstrats die Gräben, welche das plattenförmige Abdecksubstrat durchtrennen so eingefügt, daß sie zwischen den rahmenförmigen Strukturen verlaufen. Die so hergestellten, noch auf dem Trägersubstrat befestigten Abdeckteile werden dann an den rahmenförmigen Strukturen mit dem Funktionssubstrat verbunden, so daß von den rahmenförmigen Strukturen begrenzte Kavitäten definiert werden, welche die Funktionsbereiche umschließen.

Vorzugsweise wird das Einfügen der Gräben nach dem Aufbringen der rahmenförmigen Strukturen vorgenommen. Denkbar ist aber ebenso, zunächst die Gräben einzufügen und dann die rahmenförmigen Strukturen herzustellen. Ein besonders geeignetes Material für die rahmenförmigen Strukturen ist Glas.

Glas zeichnet sich durch optische Transparenz, Härte und geringe Permeabilität für Gase aus, was besonders von Vorteil ist, um einen möglichst hermetischen Einschluß der Funktionsbereiche in den Kavitäten zu erreichen. Weiterhin kann Glas auch durch Aufdampfen, also eine Abscheidung durch thermisches Verdampfen eines Targets abgeschieden werden. Vorzugsweise kommt hier Elektronenstrahlverdampfung zum Einsatz. Gegenüber anderen Abscheideverfahren, wie etwa Sputtern zeichnet sich Aufdampfen durch sehr hohe Abscheideraten aus. Um auch bei hohen Abscheideraten sehr dichte Schichten zu erzielen, hat es sich dabei auch als besonders günstig erwiesen, eine Plasmaionen-unterstütze Abscheidung (PIAD) zu verwenden. Dabei wird gleichzeitig zur Abscheidung durch thermische Verdampfung von Targetmaterial ein Ionenstrahl auf die zu beschichtende Fläche gerichtet.

Um eine strukturierte Zwischenschicht herzustellen, wird weiterhin vorzugsweise eine Photoresist-Schicht als Zwischenschicht aufgebracht und fotolithografisch strukturiert. Auf diese Weise, insbesondere auch in Verbindung mit der Herstellung der rahmenförmigen Strukturen durch Abscheidung von Glas lassen sich hochgenau strukturierte Rahmen mit ebenen Oberflächen erzeugen.

Um das Entfernen der Zwischenschicht zu erleichtern, ist es weiterhin günstig, wenn die Beschichtung mit einer Schichtdicke abgeschieden wird, die geringer ist, als die Dicke der strukturierten Zwischenschicht. Damit wird erreicht, daß die Zwischenschicht an den Rändern der Strukturen auch nach Abscheiden der Beschichtung zugänglich bleibt. Somit können beispielsweise Lösungsmittel, mit welchen die Zwischenschicht aufgelöst wird, oder Reagenzien, welche in sonstiger Weise, beispielswiese durch Zersetzung oder Aufquellen auf die Zwischenschicht wirken, an den Rändern der Strukturen in die Zwischenschicht, eindringen.

Wird das Funktionssubstrat, wie insbesondere ein Funktionswafer unter Einsatz von Prozeßschritten weiterbehandelt, die im Vakuum oder zumindest in einer Niederdruck-Atmosphäre durchgeführt werden, kann ein Druckunterschied zwischen beim Verbinden von Funktionswafer mit den Abdeckteilen in den Kavitäten eingeschlossenem Gas und der Umgebung auftreten. Beispiele für solche Prozeßschritte sind die Vakuumabscheidung von Schichten, etwa mittels Aufdampfen, Sputtern oder plasmaunterstützer chemischer Dampfphasenabscheidung. Um einen zu großen Druckunterschied und die dabei auftretenden Kräfte zu vermeiden, können Kanäle vorgesehen werden, welche die Kavitäten mit der Umgebung verbinden und einen Gasaustausch ermöglichen. Eine Möglichkeit dazu ist, rahmenförmige Strukturen herzustellen, die eine Lücke aufweisen, so daß nach dem Befestigen der Abdeckteile und dem Entfernen des Trägerssubstrats durch die Lücken Kanäle gebildet werden, welcher die Umgebung mit der Kavität verbinden. Die Kanäle können dann nachträglich verschlossen werden, insbesondere nach weiteren im Vakuum durchgeführten Behandlungsschritten.

In die Kavitäten kann weiterhin mit Vorteil ein Schutzgas eingeschlossen werden. Ein solches Schutzgas kann beispielsweise eine wasserfreie Atmosphäre sein. Damit kann etwa verhindert werden, daß Wasser an den Wandungen der Kavitäten kondensiert. Auch kann das Schutzgas sauerstofffrei oder sauerstoffarm sein, um Oxidationsprozesse, welche die Lebenstauer oder Funktionalität der Bauelemente beeinträchtigen können, zu verhindern oder zumindest zu verlangsamen. Geeignet als Schutzgas ist beispielsweise trockener Stickstoff. Bleiben die Kavitäten zunächst über Kanäle verbunden, so kann dann das Verschließen der Kanäle in einer Schutzgas-Atmosphäre erfolgen. Sind Kanäle nicht vorhanden, kann das Verbinden der Abdeckteile mit dem Funktionssubstrat in einer solchen Schutzgasatmosphäre, wie etwa trockenem Stickstoff durchgeführt werden.

Auch als Abdecksubstrat wird gemäß einer bevorzugten Ausführungsform der Erfindung ein Glassubstrat verwendet. Ein solches Substrat kann dann insbesondere als Fenster für optoelektronische Bauelemente dienen und gleichzeitig Funktionsbereiche mit optischen Sensoren und/oder Emittern verkapseln. Durch ein solches transparentes Abdecksubstrat können dann die Abdeckteile besonders vorteilhaft auch optische Fenster für die Funktionsbereiche bilden.

Um Abdeckteile zu realisieren, die kleiner als die aus dem Funktionssubstrat später herausgearbeiteten Teile, können entsprechend breite Gräben erzeugt werden, die breiter sind als die auf dem Funktionssubstrat vorgesehenen Trennbereiche. Die Trennbereiche auf dem Funktionssubstrat, wie insbesondere einem Halbleiter-Wafer werden im allgemeinen durch die Schnittbreite der verwendeten Trennwerkzeuge vorgegeben. In der Halbleiter-Fertigung werden dazu im allgemeinen entsprechende Sägen eingesetzt. Hier kann es sich anbieten, anstelle einer Verwendung von Trennwerkzeugen mit größerer Schnittbreite für das Einfügen der Gräben zum Trennen der Abdeckteile jeweils Paare von parallelen Gräben einzufügen. Damit werden, sofern die Gräben weit genug auseinanderliegen, zwischen den Abdeckteilen und zwischen den Paaren Bereiche des Abdecksubstrats weitere Teile herausgearbeitet, die später entfernt werden können.

Gemäß einer Ausführungsform der Erfindung werden die Abdeckteile auf dem Funktionssubstrat zur Befestigung aufgeklebt. Die Hermetizität einer Klebeschicht zur Verbindung reicht in vielen Fällen, vor allem für Bauelemente für den Home-Consumer-Markt aus, um die Bauelemente zu schützen und die geforderte Lebensdauer zu erreichen. Die Verwendung der Art des Klebers richtet sich nach den Anforderungen an die Klebeverbindung. Wird ein optisch transparentes Abdecksubstrat und/oder transparentes Funktionssubstrat verwendet, kann ein UV-härtbarer Kleber verwendet werden, wobei dazu der Verbund mit dem Abdecksubstrat, beziehungsweise den daraus hergestellten Abdeckteilen und dem Funktionssubstrat mit UV-Strahlung zur Härtung des Klebers bestrahlt wird, welche dann durch zumindest eines der Substrate hindurch zur Klebstoffschicht zwischen den beiden Substraten gelangt. Ist das Funktionssubstrat im UV-Bereich nicht transparent, wie insbesondere im Falle eines Halbleiterwafers mit integrierten Schaltkreisen als Funktionsbereiche, und wird ein transparentes Abdecksubstrat, wie insbesondere ein Glaswafer verwendet, so ist es hierbei auch besonders vorteilhaft, wenn auch das Trägersubstrat, auf welchem die Abdeckteile beim Aufkleben auf das Funktionssubstrat noch befestigt sind, transparent ist. Dabei bietet es sich insbesondere an, ein Glassubstrat zu verwenden.

Die Gräben werden besonders bevorzugt durch mechanischen Abtrag, wie insbesondere Sägen oder Schleifen hergestellt. Hierbei können die gleichen Werkzeuge verwendet werden, die auch für das spätere Vereinzeln der Bauelemente vom Funktionssubstrat verwendet werden. Das Abtrennen der Bauelemente wird bei der Halbleiter-Fertigung dabei auch als "Dicen" bezeichnet.

Um eine sichere Trennung der Abdeckteile vom Trägersubstrat zu erreichen, ist es weiterhin von Vorteil, wenn Gräben eingefügt werden, die teilweise in das Trägersubstrat hineinreichen. Dies ist insbesondere in Verbindung mit einem mechanischen Abtrag bevorzugt, da dann in einfacher Weise sichergestellt werden kann, daß das Abdecksubstrat durch die eingefügten Gräben jeweils vollständig durchtrennt wurde.

Vielfach weisen die Bauelemente auf dem Funktionssubstrat elektrische Anschlußstellen auf der Seite mit den Funktionsbereichen auf. Solche Anschlußstellen können insbesondere auch Bondpads für das Drahtbonden zur Kontaktierung elektronischer oder optoelektronischer Bauelemente, wie insbesondere integrierte elektronische oder optoelektronische Bauelemente sein. Um diese Bondpads frei zu halten, werden gemäß einer besonders bevorzugten Ausführungsform der Erfindung die Abdeckteile so durch Gräben abgetrennt und auf das Funktionssubstrat aufgebracht, daß die elektrischen Anschlußstellen frei liegen.

Nach dem Aufbringen der Abdeckteile auf dem Funktionssubstrat können dann unmittelbar im Anschluß oder nach Durchführung weiterer Fertigungsschritte, auch Fertigungsschritte zur Verpackung einzelne Bauteile durch Auftrennen des Funktionssubstrats entlang der Trennbereiche zwischen den Funktionsbereichen hergestellt werden.

Die Erfindung ist insbesondere zur Verkapselung elektronischer, dabei insbesondere auch optoelektronischer, und/oder mikroelektromechanischer Bauelemente auf Wafern, insbesondere auch Halbleiter-Wafern als Funktionssubstrate geeignet. Bei elektronischen oder optoelektronischen Bauelementen werden die Funktionsbereiche auf dem Wafer insbesondere durch die Schaltkreise der Bauelemente definiert, bei mikroelektromechanischen Bauelemente auch durch die mikroelektromechanischen Teile.

Die Erfindung wird nachfolgend anhand von Ausführungsbeispielen und unter Bezugnahme auf die beigeschlossenen Zeichnungen näher erläutert. Dabei verweisen gleiche Bezugszeichen auf gleiche oder ähnliche Teile.

Es zeigen:
Fig. 1 bis 11 Verfahrensschritte zur Herstellung eines Funktionswafers mit Abdeckteilen,
Fig. 12 in Aufsicht einen durch Abtrennen vom Funktionswafer hergestellten Silizium-Chip,
Fig. 13 bis X eine Variante der in Fig 1 bis 11 gezeigten Verfahrensschritte, bei welcher Abdeckteile mit Kavitäten hergestellt werden, die einen Kanal mit einer Verbindung zur Umgebung aufweisen.

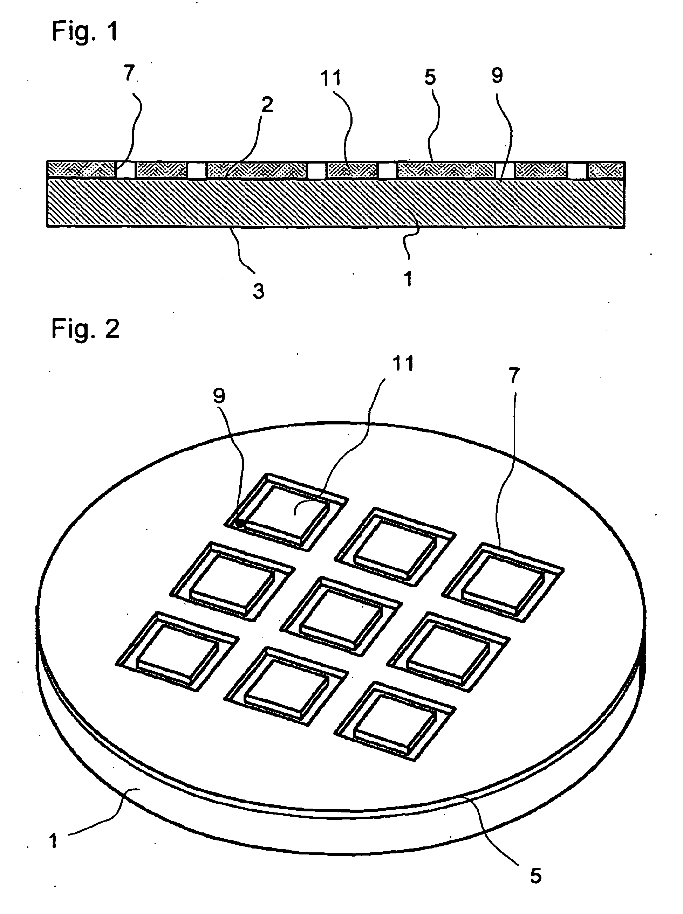

Anhand der Fig. 1 bis 11 werden im folgenden Verfahrensschritte zur Herstellung eines Funktionswafers mit Abdeckteilen zur Abdeckung von Funktionsbereichen beschrieben. Mit der Abdeckung durch die Abdeckteile werden dabei auch Kavitäten geschaffen, an welche die Funktionsbereiche des Funktionswafers angrenzen und somit von den Kavitäten umgeben werden.

Fig. 1 zeigt in einer Schnittansicht ein plattenförmiges Abdecksubstrat in Form eines Abdeckwafers 1 aus Glas mit Seiten 2, 3. Das Verfahren zur Verkapselung der Funktionsbereiche basiert nun darauf, daß auf dem. Abdeckwafer 1 eine strukturierte Zwischenschicht aufgebracht wird, welche so strukturiert ist, daß rahmenförmige Bereiche des Abdecksubstrats frei bleiben. Es wird dann eine Beschichtung auf der mit der Zwischenschicht versehenen Seite des Abdeckwafers 1 abgeschieden und die Zwischenschicht danach entfernt, so daß die Bereiche der Beschichtung, welche auf der Zwischenschicht abgeschieden sind, zusammen mit der Zwischenschicht entfernt und rahmenförmige Strukturen auf den von der Zwischenschicht freigelassenen rahmenförmigen Bereichen auf dem Abdecksubstrats erhalten werden.

Auf der freiliegenden Seite des Abdeckwafers 1 werden außerdem zwischen den rahmenförmigen Strukturen verlaufende Gräben eingefügt, welche den Abdeckwafer durchtrennen. Die auf dem Trägersubstrat befestigten Abdeckteile werden dann an den rahmenförmigen Strukturen mit dem Funktionswafer verbunden, so daß von den rahmenförmigen Strukturen begrenzte Kavitäten definiert werden, welche die Funktionsbereiche umschließen.

Zur Herstellung einer strukturierten Zwischenschicht wird eine Photoresist-Schicht 5 auf die Seite 2 des Abdeckwafers 1 aufgebracht. Diese wird dann, wie in Fig. 1 gezeigt, fotolitografisch durch Belichtung und Entwicklung strukturiert, wobei Öffnungen 7 erzeugt werden, welche rahmen- oder ringförmige Bereiche 9 der Seite 2 des Abdeckwafers 1 freilegen, die jeweils Bereiche 11 von der übrigen Photoresist-Schicht 5 abtrennen.

Fig. 2 zeigt zur Verdeutlichung schematisch eine perspektivische Ansicht des mit der strukturierten Photoresist-Schicht 5 versehenen Abdeckwafers 1. Im Beispiel sind neun derartige Strukturen mit freigelegten rahmenförmigen Bereichen dargestellt. Jede dieser Strukturen ist einem Bauelement auf einem Funktionswafer zugeordnet. Es ist dem Fachmann ersichtlich, daß bei einem realen Funktionswafer jedoch im allgemeinen wesentlich mehr Bauelemente vorhanden sind und daher entsprechend viele rahmenförmige Bereiche 9 auf dem Abdeckwafer erzeugt werden.

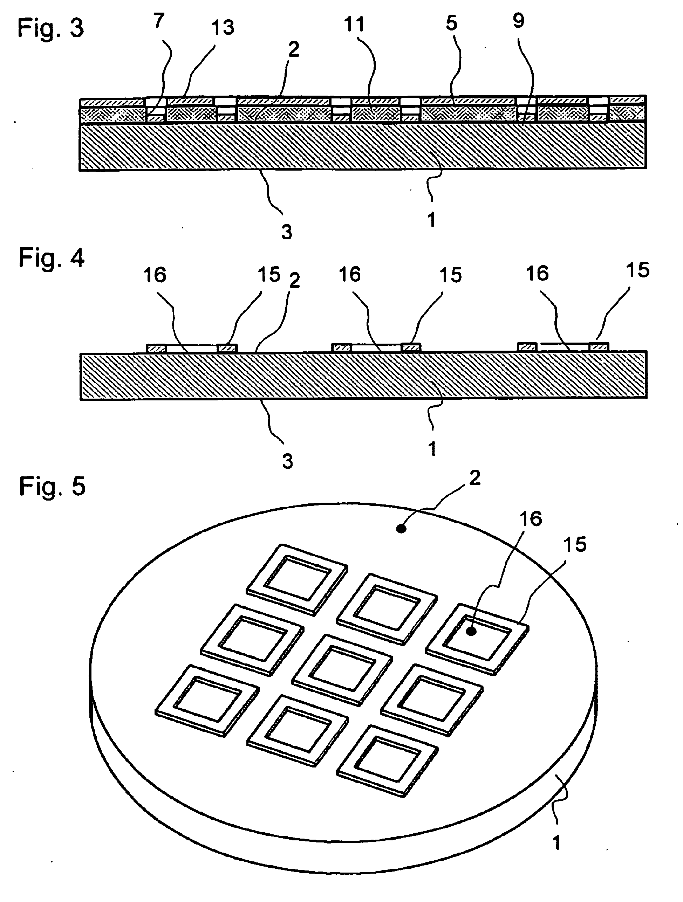

Anschließend wird eine Beschichtung auf der mit der Zwischenschicht versehenen Seite des Abdecksubstrats abgeschieden. Dieser Schritt ist in der Schnittansicht der Fig. 3 dargestellt.

Die Beschichtung ist eine durch Abscheiden von thermisch verdampftem Glas hergestellte Glasschicht 13. Das Verdampfen des dabei verwendeten Glastargets erfolgt dabei bevorzugt mit Elektronenstrahlverdampfung. Bei dieser Methode wird die Aufheizung nicht über den Kontakt mit weiteren Teilen, wie etwa einem indirekt beheizten Tiegel aufgeheizt, sondern vielmehr über einen auf das Glastarget gerichteten Elektronenstrahl. Die Leistung kann so durch geeignete Fokussierung des Elektronenstrahls auf eine kleine Fläche konzentriert werden. Damit können höhere Temperaturen auf einer kleinen Fläche auf dem Target erreicht werden. Da die Verdampfungsrate nichtlinear von der Temperatur abhängt, können so sehr hohe Verdampfungsund damit Abscheideraten bei nur geringer abgestrahlter Leistung erzielt werden, so daß auch das zu beschichtende Substrat, dementsprechend hier der Abdeckwafer 1 vergleichsweise kühl gehalten werden kann.

Als besonders geeignet zur Verwendung als Aufdampfglas haben sich Gläser erwiesen, die folgende Zusammensetzungsbereiche in Gewichtsprozent aufweisen :

| Komponenten | Glasbereich1 | Glasbereich2 |
|---|---|---|
| SiO₂ | 75 - 85 | 65 - 75 |
| O₃ | 10 - 15 | 20 - 30 |
| Na₂O | 1 -5 | 0,1 - 1 |
| Li₂O | 0,1 - 1 | 0,1 - 1 |
| K₂O | 0,1 - 1 | 0,5 - 5 |
| Al₂O₃ | 1 - 5 | 0,5 - 5 |

Bevorzugte Aufdampfgläser aus diesen Gruppen sind Gläser der Firma Schott mit der folgenden Zusammensetzung in Gewichtsprozent:

| Komponenten | Glas1 | Glas2 |
|---|---|---|
| SiO₂ | 84,1 % | 71% |
| B₂O₃ | 11,0 % | 26 |
| %Na₂O | ≈2,0 % | 0,5% |
| Li₂O | ≈0,3 % | 0,5% |
| K₂O | ≈0,3 % | 1,0% |
| Al₂O₃ | 0,5 % | 1,0% |

Die bevorzugt verwendeten Gläser besitzen insbesondere die in der nachstehenden Tabelle aufgeführten Eigenschaften:

| Eigenschaften | Glas1 | Glas2 |
|---|---|---|
| α₂₀₋₃₀₀ [10⁻⁶K⁻¹] | 2,75 | 3,2 |
| Dichte (g/cm³) | 2,201 | 2, 12 |
| Transformationspunkt [°C] | 562 °C | 466 °C |
| brechungsindex | n_{D}=1,469 | 1,465 |
| asserbeständigkeitklasse nach ISO 719 | 1 | 2 |
| Säurebeständigkeitsklasse nach DIN 12 116 | 1 | 2 |
| Laugenbeständigkeitsklasse nach DIN 52322 | 2 | 3 |
| Dielektrizitätskonstante ε (25 °C) | 4,7 (1MHz) | 3,9 (40GHz) |
| tanδ (25 °C) | 45*10⁻⁴ (1MHz) | 26*10⁻⁴ (40GHz) |

Die Beschichtung 13 wird mit einer Schichtdicke abgeschieden, die kleiner ist als die Dicke der strukturierten Zwischenschicht 5 Damit bleiben die Ränder der Zwischenschicht 5 an den Öffnungen 7 zugänglich, da in den Öffnungen 7, beziehungsweise in den freiliegenden rahmenförmigen Bereichen 9 des Abdeckwafers 1 die Zwischenschicht 5 über die abgeschiedene Glasschicht 13 hinausragt. An diesen Stellen kann dann ein Lösungsmittel auf die Zwischenschicht 5 einwirken und diese so weit anlösen, daß sie sich ablöst. Mit dem Entfernen der Zwischenschicht werden auch Bereiche der Glasschicht 13 auf der Zwischenschicht 5 mit abgelöst. Durch diesen sogenannten "Lift-off"-Prozess bleiben dann nur noch diejenigen Bereiche der Glasschicht 13 stehen, welche direkt auf der Oberfläche des Abdeckwafers 1 abgeschieden sind. Dementsprechend werden aus der Glasschicht 13, beziehungsweise den Bereichen dieser Schicht auf den rahmenförmigen freigelassenen Bereichen 9 des Abdeckwafers 1 entsprechend geformte rahmenförmige Strukturen 15 erzeugt, welche jeweils Bereiche 16 der Seite 2 des Abdeckwafers 1 umgeben. Diese Fertigungsstufe ist in der Schnittansicht der Fig. 4, sowie zur weiteren Verdeutlichung in der perspektivischen Ansicht der Fig. 5 dargestellt.

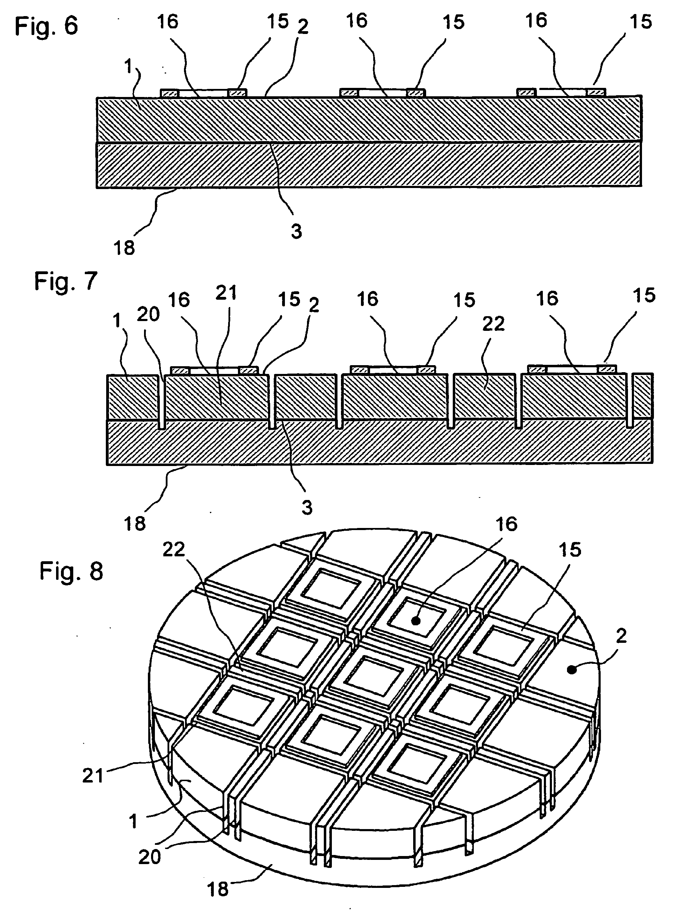

Anschließend wird, wie in der Schnittansicht der Fig. 6 gezeigt ist, der so vorbereitete Abdeck-Wafer 1 mit der Seite 3 mit einem Trägersubstrat 18 verbunden. Die Verbindung der beiden Substrate, hier also des Abdeckwafers 1 und des Trägerssubstrats 18 ist lösbar ausgestaltet. Beispielsweise kann dazu allgemein eine geeignete Klebeverbindung verwendet werden, die unter Einwirkung von Licht und/oder Lösemitteln und/oder Wärme ihre Klebekraft vermindert und das Ablösen des Trägerssubstrats 18 gestattet.

Nach dem Befestigen des Abdecksubstrats 1 auf dem Trägerssubstrat 18 werden Gräben 20 in die freiliegende Seite 2 des Abdecksubstrats 1 eingefügt. Diesen Schritt zeigt die Schnittansicht in Fig. 7, sowie die perspektivische Ansicht der Fig. 8. Die Gräben 20 werden dabei durch Sägen mit einem Trennwerkzeug durchgeführt, wie es auch zum Abtrennen von Bauelementen aus Halbleiter-Wafern in der Fertigung von elektronischen Bauelemente eingesetzt wird.

Durch das Einfügen der Gräben 20, welche durch das Abdecksubstrat 1 hindurchreichen, wird ein Verbundteil mit dem Trägersubstrat 18 und einzelnen durch die Gräben 20 voneinander getrennten, aber über das Trägersubstrat 18 miteinander verbundenen Abdeckteilen 21 erhalten, wobei bei dem gezeigten Beispiel jedes der Abdeckteile 21 eine rahmenförmige Struktur 15 aufweist.

Wie anhand der Fig. 7 und 8 ersichtlich ist, werden die Gräben 20 weiterhin so tief eingesägt, daß sie bis in das Trägersubstrat 18 hineinreichen. Auf diese Weise wird sichergestellt, daß die Abdeckteile 21 vollständig von übrigen Teilen des Abdecksubstrats 1 getrennt sind.

Außerdem werden zwischen den rahmenförmigen Strukturen 15 nicht einzelne Gräben, sondern jeweils Paare paralleler Gräben 20 eingefügt, so daß hier zwischen den Abdeckteilen weitere Teile 22 vorhanden sind, die mit dem Trägersubstrat verbunden sind. Zwar würden einzelne Gräben bereits ausreichen, um den Abdeckwafer 1 in einzelne Teile zu zerlegen, allerdings wären in diesem Fall die lateralen Abmessungen der Abdeckteile 21 durch die Breite der Gräben vorgegeben, da auch die lateralen Positionen durch die korrespondierenden lateralen Positionen der Bauelemente des zu verkapselnden Funkionswafer festgelegt sind.

Sind an einer Seite der rahmenförmigen Strukturen 15 keine weiteren dieser Strukturen mehr vorhanden, reicht selbstverständlich, wie es auch in den Fig. 7 und 8 dargestellt ist, ein einzelner Graben an dieser Seite zur Abtrennung der Abdeckteile vom übrigen Material des Abdeckwafers 1 aus.

Alternativ zur Trennung der Abdeckteile 21 durch Paare von parallelen Gräben 20 könnten aber auch entsprechend breitere einzelne Gräben 20 eingefügt werden. Um die Gräben 20 durch Dicen, beziehungsweise Sägen einzufügen, kann der Verbund mit dem Abdeckwafer 1 und dem Trägerssubstrat 20 beispielsweise auf einen Träger auf der freiliegenden Seite des Trägersubstrats 18 mittels einer Klebefolie aufgeklebt und die Klebeverbindung der Klebefolie nach dem Sägen durch Bestrahlung mit ultraviolettem Licht gelöst werden.

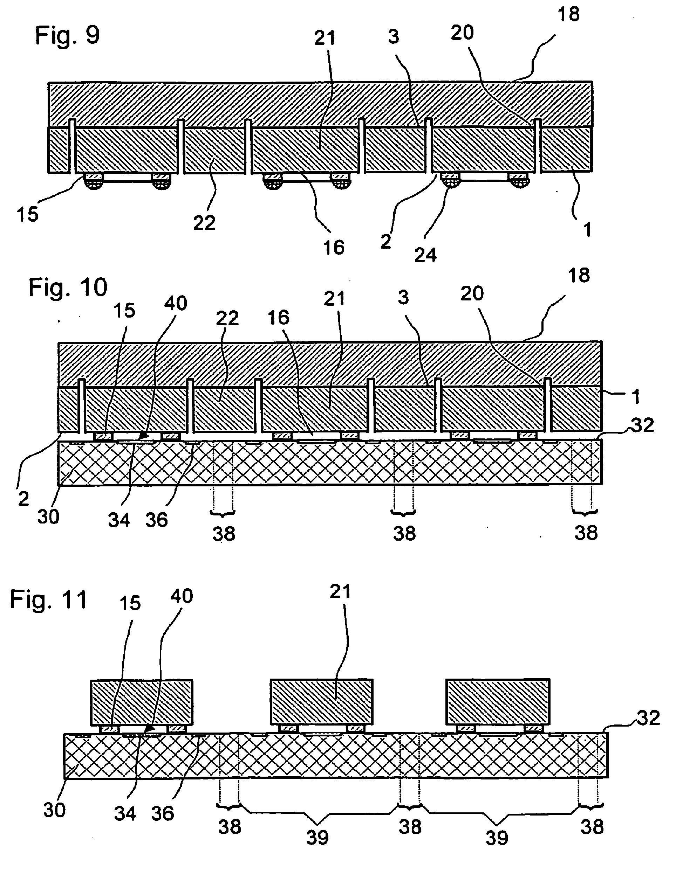

Nach dem Einfügen der Gräben 20 erfolgt die Verbindung der Abdeckteile 20 mit einem Funktionswafer. Diesen Schritt zeigen die Schnittansichten der Fig. 9 und 10. Zunächst wird, wie in Fig. 9 gezeigt, Klebstoff 24 auf die rahmenförmigen Strukturen 15 aufgebracht. Dazu wird auf eine Oberfläche eine Klebstoffschicht aufgebracht und der Verbund mit den rahmenförmigen Strukturen 15 auf diese Klebstoffschicht aufgesetzt, so daß der Klebstoff an den erhabenen rahmenförmigen Strukturen anhaftet. Das Aufsetzen erfolgt vorzugsweise in einer kontrollierten Atmosphäre, die insbesondere frei von Feuchtigkeit und/oder Sauerstoff ist, um unerwünschte Reaktionen oder Kondensation von Feuchtigkeit in den Kavitäten zu vermeiden. Beispielweise kann das Aufsetzen in einer trockenen Stickstoff-Atmosphäre vorgenommen werden.

Anschließend wird der Verbund mit den Abdeckteilen 21 und dem Trägersubstrat 18 zu einem Halbleiter-Funkionswafer 30 ausgerichtet und, wie in Fig. 10 dargestellt, auf den Funkionswafer 30 aufgesetzt. Der Funkionswafer 30 umfasst dabei bei dem gezeigten Beispiel eine Vielzahl von Funktionsbereichen 34 auf oder an der Seite 32, welche mit den Abdeckteilen 21 verbunden wird. Die Funktionsbereiche 34 können insbesondere optoelektronische Sensor-Schaltungen sein.

Zur elektrischen Kontaktierung der Funktionsbereiche 34 sind auf der Seite 32 außerdem Kontaktflächen 36 angeordnet, die insbesondere als Bond-Pads für das Drahtbonden dienen können. Bereiche 38 zwischen den Funktionsbereichen 34 und Kontaktflächen 36 sind als Trennbereiche vorgesehen. Bei der späteren Abtrennung einzelner Bauelemente mit Funktionsbereichen und Kontaktflächen 36 wird der Funktionswafer 30 entlang dieser Trennbereiche 38 aufgetrennt.

Wie anhand von Fig. 10 zu erkennen ist, wird der Verbund mit dem Trägersubstrat 18 und den damit verbundenen Abdeckteilen 21 so auf den Funktionswafer aufgesetzt und mit diesem durch den Kleber auf den rahmenförmigen Strukturen 15 verbunden, daß die Gräben 20 entlang der Trennbereiche 38 auf dem Funktionswafer zwischen den Funktionsbereichen 34 der Bauelemente verlaufen und die Abdeckteile 21 die Funktionsbereiche 34 abdecken. Aufgrund der erhabenen rahmenförmigen Strukturen 15 liegt dabei weiterhin die Seite 2 des Abdecksubstrats 1, beziehungsweise der davon abgetrennten Abdeckteile 21 nicht direkt auf der Seite 32 des Funktionswafers 30 auf. Vielmehr ist die Seite 2 des Abdecksubstrats 1 aufgrund der darauf aufgebrachten erhabenen rahmenförmigen Strukturen 15 beabstandet und es werden von den rahmenförmigen Strukturen 15 begrenzte Kavitäten 40 gebildet, an welche die Funktionsbereiche 34 angrenzen, so daß ein Funktionsbereich 34 jeweils von einer Kavität umschlossen ist. Die zu den Funktionsbereichen 34 gegenüberliegende Seite der Kavitäten 40 wird dabei jeweils von den Bereichen 16 der Seite 2 des Abdeckwafers 1, beziehungsweise der davon abgetrennten Abdeckteile 21 gebildet.

Sind die Abdeckteile 21 wie vorstehend beschrieben aufgesetzt, kann der Kleber zwischen den rahmenförmigen Strukturen 15 und der Seite 32 des Funktionswafers 30 beispielsweise durch Bestrahlung mit UV-Licht ausgehärtet werden, indem UV-Licht durch das Trägersubstrat 18, das Abdecksubstrat 1 und die rahmenförmigen Strukturen 15 hindurch UV-Licht auf die Klebestellen eingestrahlt wird. Dies ist insbesondere dann möglich, wenn für alle diese Teile Glas als Material verwendet wird. Die Verwendung eines durch Licht härtbaren Klebers ist von Vorteil, da auf diese Weise die Prozesszeit für das Aushärten der Klebeverbindung deutlich reduziert werden kann.

Nach dem Aufsetzen der Abdeckteile kann dann das Trägersubstrat 18 entfernt werden. Dazu wird die Verbindung zwischen Trägersubstrat 18 und dem Abdecksubstrat 1, beziehungsweise der davon abgetrennten Teile gelöst. Zum Beispiel kann ein unter Einwirkung von UV-Licht lösbarer Kleber verwendet werden. Dies ist ein Beispiel dafür, daß das Ablösen des Trägersubstrats und das Aushärten der Klebeverbindung zwischen den Abdeckteilen 21 und dem Funktionssubstrat zumindest teilweise gleichzeitig erfolgen kann. Wird für die Klebeverbindung zwischen den Abdeckteilen 21 und dem Funktionssubstrat ein UV-härtbarer Kleber verwendet, löst sich dann gleichzeitig zur Härtung der Klebeverbindung zwischen den Abdeckteilen 21 und dem Funktionswafer 30 unter Einwirkung des UV-Lichts die Klebeverbindung zwischen Trägersubstrat 18 und den Teilen des Abdecksubstrats 1.

Da die Teile 22 zwischen den paarweise eingefügten Gräben 20 nach dem Ablösen des Trägersubstrats 18 keine Verbindung zum Funktionswafer 30 haben, werden auch diese entfernt. Das Ergebnis, ein Verbund des Funktionswafers 30 mit einer Vielzahl von Abdeckteilen 21, welche die Funkionsbereiche 34 des Funktionswafers 30 abdecken, zeigt Fig. 11. Die lateralen Abmessungen der Abdeckteile 21 sind zumindest in einer Richtung kleiner als die Abstände, beziehungsweise die Bereiche 39 des Funktionswafers 30 zwischen den Trennbereichen 38. Insbesondere sind dabei die Abdeckteile 21 so durch das Herstellungsverfahren abgetrennt und auf das Funktionssubstrat aufgebracht worden, daß auch die elektrischen Anschlußstellen 36 frei liegen.

Bei dem vorstehend beschriebenen Ausführungsbeispiel müssen die Verfahrensschritte nicht alle in der beschriebenen Reihenfolge durchgeführt werden. So kann das Befestigen des Abdeckwafers 1 auf dem Trägersubstrat 18 auch vor dem Aufbringen und/oder Strukturieren der Photoresist-Schicht 5 oder dem Abscheiden der Glasschicht 13 oder des Lift-offs dieser Glasschicht 13 durchgeführt werden. Ebenso ist es auch möglich, das Einfügen der Gräben 20 früher als vorstehend beschrieben durchzuführen. So können die Gräben bereits vor dem Aufbringen der Photoresistschicht 5 und/oder deren Strukturierung, oder vor dem Abscheiden der Glasschicht 13 oder dem Lift-off der Glasschicht 13 zusammen mit der Photoresistschicht 5 eingefügt werden. Es ist dabei aber zweckmäßig, die Gräben 20 nach dem Befestigen des Abdeckwafers 1 auf dem Trägersubstrat 18

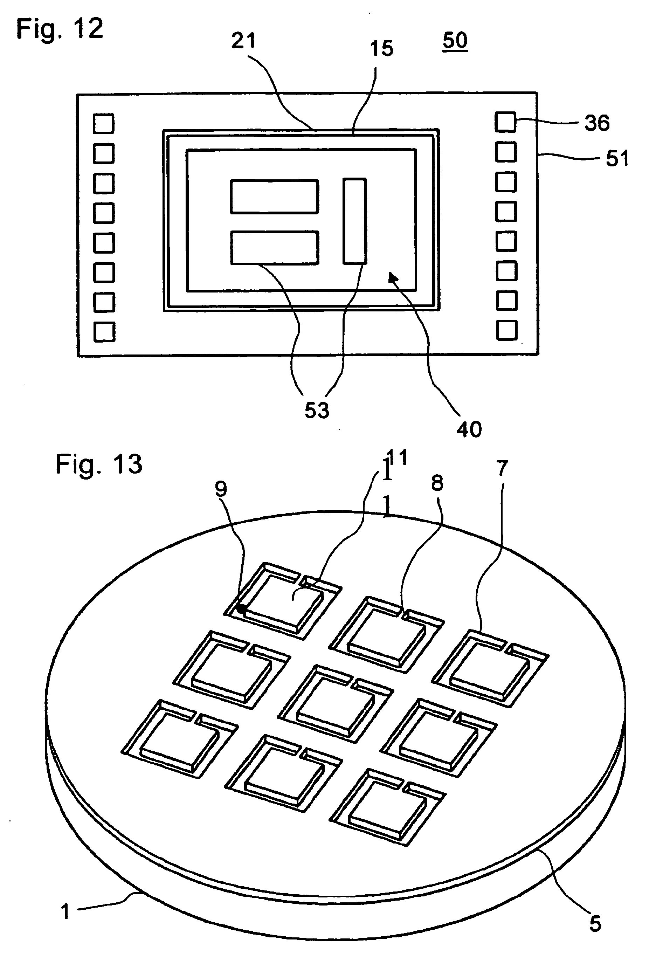

Fig. 12 zeigt in Aufsicht einen Silizium-Chip 50, wie er durch Abtrennen von einem entsprechend wie in Fig. 11 gezeigten Funktionswafer 30 entlang der Trennbereiche 38 erhalten werden kann. Das Halbleiter-Substrat 51 entspricht dabei dementsorechend einem der Bereiche 39 zwischen Trennbereichen 38 in Fig. 11. Der Funtkionsbereich des Chips 50 umfasst hier beispielhaft einen oder mehrere Sensor-Bereiche 53. Diese können zum Beispiel eine integrierte CMOS- oder CCD-Sensoranordnung umfassen. Der Funkionsbereich, beziehungsweise hier die Sensor-Bereiche 53 werden durch das Abdeckteil 21 abgedeckt und befinden sich innerhalb der rahmenförmigen Struktur 15. Die Sensor-Bereiche 53 sind damit in der zwischen der Funktionsseite des Chips 50 und dem Abdeckteil gebildeten Kavität 40 hermetisch eingeschlossen. Ein direkter Kontakt mit anderen Teilen wird durch die Kavität vermieden, so daß die Funktion der Sensorbereiche 53 dadurch nicht beeiträchtigt werden kann. Insbesondere bildet das Glas-Abdeckteil 21 ein optisches Fenster für die Sensorbereiche 53.

Die Abschlußstellen 36 liegen gut zugänglich außerhalb des Abdeckteils und können so für die elektrische Kontaktierung mittels Drahtbonden verwendet werden.

Anhand der Fig. 13 bis 14 wird im folgenden eine Variante der in Fig 1 bis 11 gezeigten Verfahrensschritte beschrieben, bei welcher Abdeckteile 21 mit Kavitäten 40 hergestellt werden, die einen Kanal mit einer Verbindung zur Umgebung aufweisen.

Fig. 13 zeigt in perspektivischer Ansicht eine Verarbeitungsstufe entsprechend zu Fig. 2. Auch bei dem in Fig. 13 gezeigten Beispiel wurde der Abdeckwafer mit einer Photoresist-Schicht 5 versehen, die anschließend durch Belichtung und Entwicklung strukturiert wird, so daß Öffnungen 7 in der Photoresist-Schicht 5 erzeugt werden, die rahmenförmige Bereiche 9 der Seite 2 des Abdeckwafers 1 freilegen. Im Unterschied zu dem in Fig. 2 gezeigten Beispiel werden hier jedoch keine geschlossenen rahmen-oder ringförmigen Bereiche 9 freigelegt. Vielmehr sind die von den ringförmigen Öffnungen 7 umgebenen inneren Bereiche 11 der Photoresist-Schicht 5 über Stege 8 der Photoresist-Schicht mit umgebenden Bereichen der Photoresist-Schicht 5 verbunden.

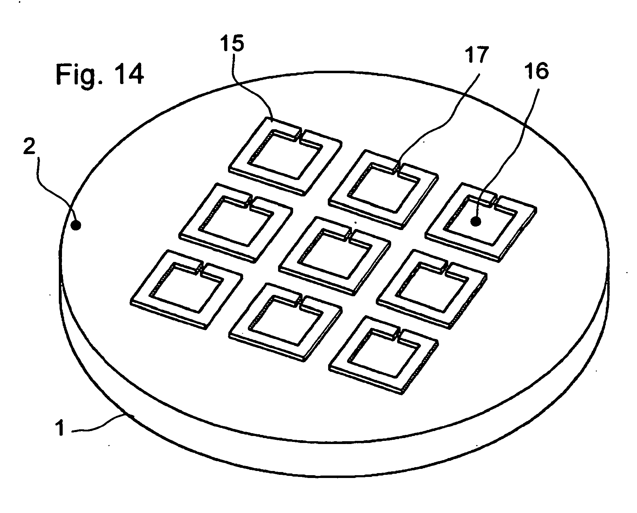

Wird anschließend eine strukturierte Glasschicht analog zu den anhand der Fig. 3 bis 5 erläuterten Verfahrensschritten hergestellt, so wird ein Abdeckwafer 1 mit rahmenförmigen Strukturen 15 erhalten, wie er in der perspektivischen Ansicht der Fig. 14 dargestellt ist. Aufgrund der Stege 8 in der Photoresist-Schicht weisen die rahmenförmigen Strukturen 15 an der Stelle der Stege 8 nun entsprechende Lücken auf.

Wird der Abdeckwafer nun, wie anhand der Fig. 6 bis 10 weiterverarbeitet und mit einem Funktionswafer verbunden, so bilden diese Lücken 17 Kanäle, welche die Kavitäten 40 mit der Umgebung verbinden. Dies ermöglicht es, den Verbund, wie er in Fig. 11 gezeigt ist, auch noch im Vakuum weiterzuverarbeiten, beispielsweise, um Schichten durch Vakuum- oder Niederdruckabscheidung, wie insbesondere Sputtern, CVD oder Aufdampfen aufzubringen. Sind diese Schritte abgeschlossen, können die Kanäle, beispielsweise durch außenseitiges Aufbringen von Kunststoff verschlossen werden. Dieses Verschließen kann in einer kontrollierten Schutzgas-Atmosphäre vorgenommen werden, die beispielsweise wasser- und/oder sauerstofffrei ist, so daß dieses Schutzgas in den Kavitäten eingeschlossen wird.

## Patentansprüche

1. Verfahren zur Herstellung verpackter Bauelemente, bei welchem ein plattenförmiges Abdecksubstrat (1) auf einem Trägersubstrat (18) befestigt und dann auf der freiliegenden Seite des plattenförmigen Abdecksubstrats (1) Gräben (20) eingefügt werden, welche das plattenförmige Abdecksubstrat (1) durchtrennen, so daß ein Verbundteil (1,18) mit dem Trägersubstrat (18) und einzelnen durch die Gräben (20) voneinander getrennten, aber über das Trägersubstrat (18) miteinander verbundenen Abdeckteile (21) erhalten wird,
und wobei dann die Abdeckteile (21) des Verbundteils (1,18) mit einem Funktionssubstrat (30) mit einer Vielzahl von Bauelementen verbunden werden, so daß die Gräben (20) entlang von Trennbereichen (38) auf dem Funktionssubstrat (30) zwischen Funktionsbereichen (34) der Bauelemente verlaufen und die Abdeckteile (21) die Funktionsbereiche (34) abdecken,
und wobei dann die Verbindung der Abdeckteile (21) mit dem Trägersubstrat (18) gelöst und das Trägersubstrat (18) entfernt und damit ein Verbund mit dem Funktionssubstrat (30) und einer Vielzahl von Abdeckteilen (21), welche Funktionsbereiche (34) abdecken, erhalten wird, **dadurch gekennzeichnet, dass** auf dem plattenförmigen Abdecksubstrat (1) eine strukturierte Zwischenschicht (5) aufgebracht wird, welche so strukturiert ist, daß rahmenförmige Bereiche (7) des Abdecksubstrats (1) frei bleiben, und wobei dann eine Beschichtung (13) auf der mit der Zwischenschicht (5) versehenen Seite des Abdecksubstrats (1) abgeschieden und die zwischenschicht (5) danach entfernt wird, wobei die Bereiche der Beschichtung (13), welche auf der Zwischenschicht (5) abgeschieden sind, zusammen mit der Zwischenschicht (5) entfernt und erhabene rahmenförmige Strukturen (15) auf den von der Zwischenschicht freigelassenen rahmenförmigen Bereichen (7) auf dem Abdecksubstrats (1) erhalten werden,
und wobei die Beschichtung (5) zur Herstellung der rahmenförmigen Strukturen (15) durch Aufdampfen von Glas abgeschieden wird, und wobei
auf der freiliegenden Seite des plattenförmigen Abdecksubstrats (1) die Gräben (20), welche das plattenförmige Abdecksubstrat (1) durchtrennen, so eingefügt werden, daß sie zwischen den rahmenförmigen Strukturen verlaufen (15), und wobei dann die auf dem Trägersubstrat (18) befestigten Abdeckteile (21) an den rahmenförmigen Strukturen (15) mit dem Funktionssubstrat (30) verbunden werden, so daß von den rahmenförmigen Strukturen (15) begrenzte Kavitäten (40) definiert werden, welche die Funktionsbereiche (34) umschließen.

2. Verfahren gemäß Anspruch 1, bei welchem die Gräben (20) so eingefügt werden, daß die Abdeckteile (21) in zumindest einer Richtung entlang der Seite des Funktionssubstrats (30), auf welche die Abdeckteile (21) aufgebracht werden, jeweils eine kleinere Abmessung als der Bereich zwischen zwei Trennbereichen (38) aufweisen.

3. Verfahren gemäß einem der vorstehenden Ansprüche, **dadurch gekennzeichnet, daß** eine Photoresist-Schicht als Zwischenschicht (5) aufgebracht und fotolithografisch strukturiert wird.

4. Verfahren gemäß Anspruch 3, **dadurch gekennzeichnet, daß** die Beschichtung (13) mit einer Schichtdicke abgeschieden wird, die geringer ist, als die Dicke der strukturierten Zwischenschicht (5).

5. Verfahren gemäß einem der vorstehenden Ansprüche, **dadurch gekennzeichnet, daß** ein Glas-Abdecksubstrat (1) verwendet wird.

6. Verfahren gemäß einem der vorstehenden Ansprüche, **dadurch gekennzeichnet, daß** die Abdeckteile (21) voneinander jeweils durch Paare von parallelen Gräben (20) getrennt werden.

7. Verfahren gemäß einem der vorstehenden Ansprüche, **dadurch gekennzeichnet, daß** die Abdeckteife (21) auf dem Funktionssubstrat (30) zur Befestigung aufgeklebt werden.

8. Verfahren gemäß dem vorstehenden Anspruch, **dadurch gekennzeichnet, daß** die Abdeckteile (21) auf dem Funktionssubstrat (30) mit einem UV-härtbaren Kleber aufgeklebt werden.

9. Verfahren gemäß einem der vorstehenden Ansprüche, **dadurch gekennzeichnet, daß** das Abdecksubstrat (1) auf dem Trägersubstrat (18) mittels eines UV-lösbaren Klebers aufgeklebt und zum Ablösen des Trägersubstrats (18) vom Abdecksubatrat (1) der Kleber mit UV-Licht bestrahlt wird.

10. Verfahren gemäß einem der vorstehenden Ansprüche, **dadurch gekennzeichnet, daß** das Abdecksubstrat (1) auf einem Glas-Trägersubstrat (18) befestigt wird.

11. Verfahren gemäß einem der vorstehenden Ansprüche, **dadurch gekennzeichnet, daß** Gräben (30) eingefügt werden, die teilweise in das Trägersubstrat (18) hineinreichen.

12. Verfahren gemäß einem der vorstehenden Ansprüche, **dadurch gekennzeichnet, daß** die Bauelemente elektrische Anschlußstellen (36) auf der Seite mit den Funktionsbereichen (34) aufweisen, und wobei die Abdeckteile (21) so durch Gräben (20) abgetrennt und auf das Funktionssubstrat (30) aufgebracht werden, daß die elektrischen Anschlußstellen (36) frei liegen.

13. Verfahren gemäß einem der vorstehenden Ansprüche, **dadurch gekennzeichnet, daß** einzelne Bauteile durch Auftrennen des Funktionssubstrats (30) entlang der Trennbereiche (38) zwischen den Funktionsbereichen (34) hergestellt werden.

14. Verfahren gemäß einem der vorstehenden Ansprüche, bei welchem elektronische, optoelektronische oder mikroelektromechnische Bauelemente auf einem Wafer mit den Abdeckteilen (21) verkapselt werden.

15. Verfahren gemäß einem der vorstehenden Ansprüche, **dadurch gekennzeichnet, daß** die Abdeckteile (21) optische Fenster für die Funktionsbereiche (34) bilden.

## Claims

1. Method for the manufacture of packaged components, in which a plate-shaped covering substrate (1) is attached to a carrier substrate (18) and then trenches (20) are introduced on the uncovered side of the plate-shaped covering substrate (1) and divide the plate-shaped covering substrate (1) so that a composite part (1, 18) is obtained with the carrier substrate (18) and individual covering parts (21) which are separated from each other by the trenches (20) but connected to each other by the carrier substrate (18),
and wherein the covering parts (21) of the composite part (1, 18) are then connected to a functional substrate (30) with a plurality of components, so that the trenches (20) extend along separating areas (38) on the functional substrate (30) between functional areas (34) of the components, and the covering parts (21) cover the functional areas (34),
and wherein the connection of the covering parts (21) to carrier substrate (18) is then released and the carrier substrate (18) is removed and therefore a composite with the functional substrate (30) and a plurality of covering parts (21), which cover functional areas (34), is obtained, **characterised in that** a structured intermediate layer (5) is applied to the plate-shaped covering substrate (1), which intermediate layer is structured so that framed-shaped areas (7) of the covering substrate (1) remain uncovered, and wherein then a coating (13) is deposited on the side of the covering substrate (1) which is provided with the intermediate layer (5), and the intermediate layer (5) is then removed, wherein the areas of the coating (13), which are deposited on the intermediate layer (5), are removed together with the intermediate layer (5), and raised, frame-shaped structures (15) are obtained on the frame-shaped areas (7) on the covering substrate (1) which are left uncovered by the intermediate layer,
and wherein the coating (5) for producing the frame-shaped structures (15) is deposited by vapour deposition of glass, and wherein
on the uncovered side of the plate-shaped covering substrate (1), the trenches (20), which divide the plate-shaped covering substrate (1), are introduced in such a way that they extend between the frame-shaped structures (15),
and wherein the covering parts (21) which are attached to the carrier substrate (18) are then connected to the frame-shaped structures (15) with the functional substrate (30) so that cavities (40) defined by the frame-shaped structures (15) are defined and enclose the functional areas (34).

2. Method as claimed in claim 1, in which, in at least a direction along the side of the functional substrate (30) on which the covering parts (21) are applied, the trenches (20) are introduced in such a way that the covering parts (21) are each of a smaller dimension than the area between two separating areas (38).

3. Method as claimed in any one of the preceding claims, **characterised in that** a photoresist layer is applied as the intermediate layer (5) and is structured photolithographically.

4. Method as claimed in any of claim 3 *[sic]*, **characterised in that** the coating (13) is deposited at a layer thickness which is less than the thickness of the structured intermediate layer (5).

5. Method as claimed in any one of the preceding claims, **characterised in that** a glass covering substrate (1) is used.

6. Method as claimed in any one of the preceding claims, **characterised in that** the covering parts (21) are each separated from each other by pairs of parallel trenches (20).

7. Method as claimed in any one of the preceding claims, **characterised in that** the covering parts (21) are adhered to the functional substrate (30) for attachment purposes.

8. Method as claimed in the preceding claim, **characterised in that** the covering parts (21) are adhered to the functional substrate (30) with a UV-curable adhesive.

9. Method as claimed in any one of the preceding claims, **characterised in that** the covering substrate (1) is adhered to the carrier substrate (18) by means of a UV-releasable adhesive, and the adhesive is irradiated with UV light in order to release the carrier substrate (18) from the covering substrate (1).

10. Method as claimed in any one of the preceding claims, **characterised in that** the covering substrate (1) is attached to a glass carrier substrate (18).

11. Method as claimed in any one of the preceding claims, **characterised in that** trenches (30) are introduced which extend partially into the carrier substrate (18).

12. Method as claimed in any one of the preceding claims, **characterised in that** the components have electrical connection sites (36) on the side with the functional areas (34), and wherein the covering parts (21) are separated by trenches (20) and applied to the functional substrate (30) so that the electrical connection sites (36) are uncovered.

13. Method as claimed in any one of the preceding claims, **characterised in that** individual components are produced by separating the functional substrate (30) along the separating areas (38) between the functional areas (34).

14. Method as claimed in any one of the preceding claims, in which electronic, optoelectronic or microelectromechanical components are encapsulated on a wafer with the covering parts (21).

15. Method as claimed in any one of the preceding claims, **characterised in that** the covering parts (21) form optical windows for the functional areas (34).

## Revendications

1. Procédé pour fabriquer des composants conditionnés, dans lequel un substrat de recouvrement (1) en forme de plaque est fixé sur un substrat support (18) et des rainures (20) sont insérées ensuite sur le côté mis à nu du substrat de recouvrement (1) en forme de plaque, lesquelles rainures séparent le substrat de recouvrement (1) en forme de plaque, de sorte qu'on obtient une partie mixte (1, 18) avec le substrat support (18) et des parties de recouvrement (21) individuelles, séparées les unes des autres par les rainures (20), mais reliées les unes aux autres par le substrat support (18),
et les parties de recouvrement (21) de la partie mixte (1, 18) avec un substrat de fonction (30) étant reliées avec une pluralité de composants, de sorte que les rainures (20) sont agencées le long de zones de séparation (38) sur le substrat de fonction (30) entre des zones de fonction (34) des composants et les parties de recouvrement (21) recouvrent les zones de fonction (34),
et la liaison des parties de recouvrement (21) avec le substrat support (18) étant alors détachée et le substrat support (18) étant enlevé et ainsi un assemblage avec le substrat de fonction (30) et une pluralité de parties de recouvrement (21), qui recouvrent des zones de fonction (34), étant obtenu, **caractérisé en ce que** sur le substrat de recouvrement (1) en forme de plaque est appliquée une couche intermédiaire (5) structurée, qui est structurée de telle sorte que des zones (7) en forme de cadre du substrat de recouvrement (1) restent libres, et un revêtement (13) étant alors déposé sur le côté, doté de la couche intermédiaire (5), du substrat de recouvrement (1) et la couche intermédiaire (5) étant ensuite enlevée, les zones du revêtement (13), qui sont déposées sur la couche intermédiaire (5), étant enlevées en même temps que la couche intermédiaire (5) et des structures (15) en forme de cadre, en relief, étant obtenues sur les zones (7) en forme de cadre, libérées par la couche intermédiaire, sur le substrat de recouvrement (1),
et le revêtement (13) étant déposé pour la fabrication des structures (15) en forme de cadre par métallisation de verre, et
les rainures (20), qui séparent le substrat de recouvrement (1) en forme de plaque, étant insérées sur le côté mis à nu du substrat de recouvrement (1) en forme de plaque, de telle sorte qu'elles s'étendent entre les structures (15) en forme de cadre, et les parties de recouvrement (21) fixées sur le substrat support (18) étant reliées sur les structures (15) en forme de cadre au substrat de fonction (30), de sorte que des cavités (40) limitées par les structures (15) en forme de cadre sont définies, lesquelles entourent les zones de fonction (34).

2. Procédé selon la revendication 1, dans lequel les rainures (20) sont insérées de telle sorte que les parties de recouvrement (21) présentent dans au moins une direction le long du côté du substrat de fonction (30), sur lequel les parties de recouvrement (21) sont appliquées, à chaque fois une dimension plus petite que la zone entre deux zones de séparation (38).

3. Procédé selon l'une des revendications précédentes, **caractérisé en ce qu'**une couche de résine photosensible est appliquée comme couche intermédiaire (5) et est structurée par photolithographie.

4. Procédé selon la revendication 3, **caractérisé en ce que** le revêtement (13) est déposé avec une épaisseur de couche qui est inférieure à l'épaisseur de la couche intermédiaire (5) structurée.

5. Procédé selon l'une des revendications précédentes, **caractérisé en ce qu'**un substrat de recouvrement en verre (1) est utilisé.

6. Procédé selon l'une des revendications précédentes, **caractérisé en ce que** les parties de recouvrement (21) sont séparées les unes des autres à chaque fois par des paires de rainures (20) parallèles.

7. Procédé selon l'une des revendications précédentes, **caractérisé en ce que** les parties de recouvrement (21) sont collées sur le substrat de fonction (30) pour la fixation.

8. Procédé selon la revendication précédente, **caractérisé en ce que** les parties de recouvrement (21) sont collées sur le substrat de fonction (30) avec un adhésif durcissable aux UV.

9. Procédé selon l'une des revendications précédentes, **caractérisé en ce que** le substrat de recouvrement (1) est collé sur le substrat support (18) au moyen d'un adhésif détachable aux UV et **en ce que** l'adhésif est irradié avec de la lumière UV pour le décollement du substrat support (18) du substrat de recouvrement (1).

10. Procédé selon l'une des revendications précédentes, **caractérisé en ce que** le substrat de recouvrement (1) est fixé sur un substrat support en verre (18).

11. Procédé selon l'une des revendications précédentes, **caractérisé en ce que** des rainures (30) sont insérées, lesquelles s'étendent partiellement dans le substrat support (18).

12. Procédé selon l'une des revendications précédentes, **caractérisé en ce que** les composants présentent des points de branchement électrique (36) sur le côté avec les zones de fonction (34), et les parties de recouvrement (21) étant séparées ainsi par des rainures (20) et appliquées sur le substrat de fonction (30), de sorte que les points de branchement électriques (36) sont mis à nu.

13. Procédé selon l'une des revendications précédentes, **caractérisé en ce que** des composants individuels sont fabriqués par séparation du substrat de fonction (30) le long des zones de séparation (38) entre les zones de fonction (34).

14. Procédé selon l'une des revendications précédentes, dans lequel des composants électroniques, optoélectroniques ou microélectroniques sont encapsulés sur une tranche de silicium avec les parties de recouvrement (21).

15. Procédé selon l'une des revendications précédentes, **caractérisé en ce que** les parties de recouvrement (21) forment des fenêtres optiques pour les zones de fonction (34).
